Europäisches Patentamt

(19) European Patent Office

Office européen des brevets

(11) Publication number: **0 048 064**
A1

## (12) EUROPEAN PATENT APPLICATION

(21) Application number: 81201010.6

(22) Date of filing: 09.09.81

(51) Int. Cl.³: **H 04 L 3/00**

(30) Priority: 17.09.80 NL 8005189

(43) Date of publication of application:
24.03.82 Bulletin 82/12

(84) Designated Contracting States:
AT BE CH DE FR GB IT LI LU NL SE

(71) Applicant: BSO/AUTOMATION TECHNOLOGY B.V.
Kon. Wilhelminalaan 5 P.O. Box 8348
NL-3503 RH Utrecht(NL)

(72) Inventor: Witkam, Anthonius Petrus Maria
Herenstraat 50
NL-2313 AL Leiden(NL)

(74) Representative: van der Beek, George Frans et al,
Nederlandsch Octrooibureau Johan de Wittlaan 15 P.O.
Box 29720
NL-2502 LS Den Haag(NL)

(54) Method and system for transmitting information in a communication system.

(57) Method for transmitting information in a communication system, especially a mass communication system, comprising a number of transmitting stations, a number of receiving stations and transmission links between said transmitting and receiving stations.

Information in a natural language is supplied at the input of the transmitting stations and said information is delivered in a natural language at the output of said receiving stations. In said transmitting stations the information is translated from the natural language into esperanto, whereafter the translated information is encoded in a suitable code for transmission to said receiving stations. Therein the information is translated from the encoded esperanto into the same or another natural language.

EP 0 048 064 A1

1

Method and system for transmitting information in a communication system.

The invention relates to a method for transmitting information in a communication system , especially a mass communication system, comprising a number of transmitting stations, a number of receiving stations and transmission links between said transmitting and receiving stations, whereby information in a natural language is supplied at the input of said transmitting stations and said information is delivered in a natural language at the output of said receiving stations. Furthermore the invention relates to a system for carrying out such a method.

Such methods for transmitting information are commonly known. An example thereof is the telex network in which messages in a natural language are keyed in by means of a keyboard at the transmitting side and are received by means of a printing unit at the receiving side.

Further examples are systems in which information by means of a keyboard, a video camera or other means is fed in at the transmitting side and is displayed on the screen of a television receiver at the receiving side.

In all such systems the information is available at the transmitting side in the form of a message in natural language, is suitably encoded in the transmitting station, transmitted over the transmission links to the receiving stations, decoded in said receiving stations and displayed or in another way made available in the same natural language.

There is a strong need for systems in which it is possible to input the information in the form of a message in a first natural language in the transmitting stations and to make said information available to users after receiving said information in the receiving stations in another natural language. To realize said object it is necessary that the original information in the first natural language is translated into the second natural language in which the message should be made available at the receiving side. Until now human assistence is thereby indispensable. In practice such messages are translated by human translaters at the transmitting side into the natural language, desired at the receiving side, and thereafter the message is in this translated form transmitted over the transmission links to the receiving stations.

Because of the increasing use of such communication systems said human link will evoke increasing and on the long run probably insurmountable problems.

One has already tried to make use of suitably programmed computers to translate messages from a first natural language into a second natural language. In translation systems of the very simple type the supplied message is translated word by word from the one natural language into the other natural language. That results however directly into a number of problems, for instance in the translation of words with a multiple significance. Also in further developed translation systems there are problems, for instance with idiomatic expressions, metaphors, homonyms, pronominal references, prepositional word groups, discontinuous word groups etc.

In the known translation systems one has tried first of all to analyse the supplied message by means of an analysing process such that also when homonyms, pronominal references etc are encountered it is unambiguously clear how the related words should be translated. Thereafter the separately translated words are combined in a synthesing process resulting into the message in the desired natural language taking into account the syntax of said object language. In practice it appears that it is not possible to completely eliminate the human assistence in such system if one wants to obtain a reasonably readible translation of the message.

An object of the invention is now to provide a method and system for transmitting information in a communication system in which messages in the one natural language are supplied at a transmitting station and are made available at the receiving side in a natural language, which may be another language than the language at the transmitting side, without the necessity of human assistence at the receiving side to obtain an understandible message in the desired natural language at the receiving side.

Said object is reached by means of a method of the above mentioned type, characterized in that in said transmitting stations the information is translated from the national language into esperanto whereafter the translated information is encoded such that the information can be transmitted over said transmission links to said receiving stations in which the information is translated from the encoded esperanto into a natural language, which may be another language than the language used at the transmitting side.

By using esperanto as intermediate language the eventual encountered translation problems in relation to homonyms, pronominal references, prepositional word groups etc are restricted to the analysing process.

This analysing process is completely carried out at the transmitting side. If at the transmitting side the message is translated from the natural language into esperanto by means of a suitable device, eventually with human assistence, or without a device only by a human translater, then one has at the transmitting side a message which does not contain such homonyms, pronominal references etc anymore, because said linguistic problems are not encountered in esperanto. If the message is received at the receiving side after transmission over the transmission links, then it is only necessary to carry out a relatively simple synthising process to translate the message from esperanto into the desired natural language. Because the unambiguity of the words in esperanto and because of the fact that the esperanto language inherently contains sufficient details to avoid unclearness, ambiguities etc with certainty this synthising process can be carried out very easily by means of an automatic functioning synthesis translation device.

By using the invention the human factor is restricted to the process at the transmitting side. It will be clear that this is an enormous advantage in communication systems in which a relatively small number of transmitting stations is used together with a relative extended number of receiving stations, for instance in television systems. An example thereof is for instance a view data system or a similar system in which messages from a central transmitting station are supplied into the transmission network. By using the invention the transmission network is not bounded anymore to a predetermined country or to a group of users speaking a certain language, but instead thereof it is possible to realize a much more extended network covering a number of countries and having subscribers which are speaking different languages. Each of the receiving stations of the subscribers comprises an automatic functioning synthesis translation device, adapted to the language in which the subscriber concerned wishes to receive the messages, so that regardless of the language in which the message is supplied in one of the central transmitting stations, each subscriber receives said message into his personally desired language.

In many mass communication systems, for instance view data systems, the same information has to be made available at the receiving side a number of times. It is now possible to install memory means into the transmitting stations, for instance memories in which the messages are stored after the analysing process is carried out. Thereafter it is possible to transmit said messages a number of times without the necessity to carry out each time the relatively complicated analysing process. In this way a diversion is made between the relative difficult, however less frequent occurring and in many cases only once occurring analysing process and the relative very frequently occurring however much simpler synthesising process. The advantage there of is that the means for carrying out said synthesising process in the receiving stations are relatively cheap, so that an extended market for such synthesising means can be created justifying the relatively high costs for the analysing process carried out by the information supplier.

In a preferred embodiment of the method according to the invention the words or word parts of the information, translated into esperanto, are encoded into a code suitable for transmission. Instead of the usual character by character encoding in said preferred embodiment an encoding method is used in which each esperanto word or each esperanto word section is encoded by a code word consisting of a number of code symbols, resulting into a significant saving in the number of code symbols to be transmitted. An esperanto word section may for instance be a root or suffix including the grammatical ending. In that case the morfological dissection of words during the synthesising process is eliminated. Also the synthesising process is accelerated by invariency of word section meaning in esperanto. By means of this information compression the costs of the transmission may be reduced significantly, also because these costs are at an increasing rate calculated on the basis of information volume.

5

In a further preferred embodiment the frequency with which words or word sections are occurring is taken into account during encoding such that words or word sections with a frequency of occurrence above a predetermined threshold value are encoded with variable length coding and words or word sections with a frequency of occurrence below said threshold value are encoded with a fixed length code. In that case the number of code symbols to be transmitted is furthermore reduced.

The invention furthermore provides a system for carrying out one of the above mentioned methods comprising a number of transmitting stations, a number of receiving stations and transmission links between said transmitting and receiving stations, which system is characterized in that at least a number of transmitting stations can comprise an analysis translation unit by means of which the information supplied at the input of the related transmitting station in the natural language, is translated into esperanto, and the receiving stations comprise a synthesis translation unit by means of which the received information is translated from esperanto into a natural language, which may be another language than the natural language used at the transmitting side.

If the invention is used in an already existing communication system, then the information, translated into esperanto, may contain a key code for activating the synthesis translation unit.

It is possible to use the invention advantageously not only for view data systems or similar systems, but also for transmitting press messages from a certain press agency to other press agencies scattered all over the world, whereby the transmitting press agency translates the message by means of an analysis translation unit, assisted by a human translater or not, whereby furthermore each of the receiving agencies has a receiving device, containing a completely independent functioning synthesis translation unit, by means of which the transmitted message is directly converted into the desired language in each of the receiving press agencies.

Furthermore the invention can be advantageously used by advertisers in television systems broadcasting commercial messages in their own language and also in the language of a country or group of people speaking another language, which country or group is also able to receive the television transmission containing said messages. In that case it is necessary to install an analysis translation unit and/or use the assistence of a human translater in the television broadcasting station to translate the messages into esperanto, whereby each of the receivers has a synthesis translation unit for converting the received messages from esperanto into the desired natural language and for displaying the message in said language onto the screen of the television receiver.

It is also possible to use the invention for subtitling television programs which can be received in several countries and/or by subscribers speaking different languages.

The invention is not restricted to the use of key boards, printers or television screens as input or output means, but can also be used in systems with document readers, speech synthesizers, picture display units at the transmitting and/or receiving side of the system.

Furthermore it will be clear that also languages directly derived from esperanto are falling within the scope of the invention.

## C L A I M S.

1. Method for transmitting information in a communication system, especially a mass communication system, comprising a number of transmitting stations, a number of receiving stations and transmission links between said transmitting and receiving stations, whereby information in a natural language is supplied at the input of said transmitting station and said information is delivered in a natural language at the output of said receiving stations, <u>characterized in that</u> in said transmitting stations the information is translated from the natural language into esperanto, whereafter the translated information is encoded such that the information can be transmitted over said transmission links to said receiving stations in which the information is translated from the encoded esperanto into a natural language, which may be another language than the language used at the transmitting side.

2. Method according to claim 1, <u>characterized in that</u> the information, translated into esperanto, is encoded word by word to a code suitable for transmission.

3. Method according to claim 1, <u>characterized in that</u> the information, translated into esperanto, is encoded per word section, namely per root or suffix including grammatical ending, into a code suitable for transmission.

4. Method according to claims 2 or 3, <u>characterized in that</u> the frequency with which words or word sections occur is taken into account during encoding such, that words or word sections with an occurrence frequency above a predetermined threshold value are encoded with a variable length code and words or word sections with an occurrence frequency below said threshold value are encoded with a fixed length code.

5. System for carrying out the method according to one of the preceding claims, comprising a number of transmitting stations, a number of receiving stations and transmission links between said transmitting and receiving stations, <u>characterized in that</u> at least a number of transmitting stations comprises an analysis translation unit by means of which the information, supplied at the input of the related transmitting station in the natural language is translated into esperanto, and the receiving stations comprise a synthesis

8

translation unit by means of which the received information is translated from esperanto into a natural language, which may be another language than the language used at the transmitting side.

———————

# EUROPEAN SEARCH REPORT

| Category | Citation of document with indication, where appropriate, of relevant passages | Relevant to claim |
|---|---|---|
| | IBM TECHNICAL DISCLOSURE BULLETIN vol. 3, no. 8 January 1961, New York, US R.W. BEMER: "Data compression system", pages 8,9 <br><br> * Page 9, lines 5-7, 9-12 * <br><br> -- | 1,2,4, 5 |
| | IBM TECHNICAL DISCLOSURE BULLETIN, vol. 19 , no. 9, February 1977 New York, US D. WILD: "Dynamic message coding", pages 3594,3595. <br><br> * Page 3594, lines 5-9 * <br><br> -- | 1,3 |
| | PROCEEDINGS OF THE COMPCON. FALL 79, 19th IEEE Computer Society International Conference", Washington, 4-7 September 1979, IEEE New York, US S.K. WYCKOFF: "Computer-assisted translation mainframe to micro-processor", pages 472-476 <br><br> * Page 473, left-hand column, lines 10-15 * <br><br> ----- | 1,5 |

## CLASSIFICATION OF THE APPLICATION (Int. Cl.³)

H 04 L    3/00

### TECHNICAL FIELDS SEARCHED (Int. Cl.³)

H 04 L    3/00
                21/00
                23/00
                25/16
G 06 F  15/38
G 09 B  19/06
H 04 B    1/66

### CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 22-12-1981 | GEISLER |

EPO Form 1503.1   06.78